# EUROPÄISCHE PATENTSCHRIFT

(11) **EP 3 513 392 B1**
(45) Veröffentlichungstag und Bekanntmachung des Hinweises auf die Patenterteilung: **01.03.2023**
(21) Anmeldenummer: 17758067.7
(22) Anmeldetag: 08.08.2017
(51) Int. Cl.: G08B 17/10, H02H 1/00, B60L 3/04, G08B 17/117, G08B 17/12, H05K 7/14

(54) **SICHERHEITSVORRICHTUNG**
SECURITY DEVICE
DISPOSITIF DE SÉCURITÉ

(30) Priorität: 13.09.2016 DE 102016217431
(43) Veröffentlichungstag der Anmeldung: 24.07.2019
(73) Patentinhaber: Robert Bosch GmbH, 70442 Stuttgart (DE)
(72) Erfinder: SIEVERT, Holger, 71634 Ludwigsburg (DE); GARCIA ALVAREZ, Vicente, 70435 Stuttgart (DE); LORENZ, Gerd, 72762 Reutlingen (DE)
(86) Internationale Anmeldenummer: PCT/EP2017/069984
(87) Internationale Veröffentlichungsnummer: WO 2018/050360

(56) Entgegenhaltungen:
- WO-A1-2014/194379
- DE-U1-202005 011 504
- US-A1- 2014 125 487

## Beschreibung

Die vorliegende Erfindung betrifft eine Sicherheitsvorrichtung gemäß dem Oberbegriff des Anspruchs 1, wie aus der US 2014/0125487 A1 bekannt.

Lichtschranken zur Partikeldetektion sind aus der WO 2014/194379 A1 bekannt.

Die DE 20 2005 011 504 U1 beschreibt einen Lichtbogenmelder, der einen Hochfrequenzempfänger aufweist.

### Stand der Technik

Elektrofahrzeuge und Hybridfahrzeuge verfügen üblicherweise über einen Elektromotor, der die gesamte oder einen Teil der Antriebsleistung liefert.

In Hybridfahrzeugen wird ein Teil der, bei Elektrofahrzeugen die gesamte Antriebsleistung mit einem Elektromotor erzeugt. Die elektrische Energie muss mittels Leistungselektronik auf die für den elektrischen Antriebsmotor passende Spannung und Frequenz umgewandelt werden. Dafür werden leistungsstarke Gleichstromsteller und Wechselrichter verwendet, welche bei Hybridfahrzeugen die Energie bei Generatorbetrieb des Motors auch zur Zwischenspeicherung in Akkumulatoren oder Doppelschicht-Kondensatoren aufbereiten. Die unter Hochspannung stehenden Komponenten werden häufig auf geringstem Raum im jeweiligen Gehäuse angeordnet, um Platz einzusparen. Daraus folgt, dass aufgrund kleiner Abstände bzw. durch Metallsplitter oder andere mögliche leitfähige Verunreinigungen ein Lichtbogen bzw. Störlichtbogen entstehen kann.

So müssen beispielsweise in Hochspannungs-DC Anwendungen, wie bspw. dem elektrischen Antriebsstrang eines Hybrid-Kfz zur Vermeidung von Kurzschlüssen und Lichtbögen im Gerät entsprechend den im Betrieb auftretenden Spannungen, dem zu berücksichtigenden Verschmutzungsgrad, der Homogenität der elektrischen Feldverteilung für Basis- und Funktionsisolierung Mindest-Abstände für Luft- und Kriechwege eingehalten werden. Eine Prämisse für die Festlegung dieser Mindest-Abstände ist, dass bei der Montage des Geräts und anhaftend an im Gerät eingebauten Komponenten keine leitfähigen Partikel entstehen oder eingetragen werden, die eine in den Sicherheitszuschlägen der Luft- und Kriechstrecken definierte Größe überschreiten. Die Lieferanten der Gerätekomponenten können die Maximalgröße eingetragener bzw. anhaftender Partikel (sog. "Flitter") nachteilig jedoch nur mit einer endlichen Wahrscheinlichkeit sicherstellen. Auch durch Feuchtigkeit und ungewollte Betauung kann ein Lichtbogen entstehen. Ein Störlichtbogen oder auch Fehlerlichtbogen ist in der elektrischen Energietechnik ein technisch unerwünscht auftretender Lichtbogen zwischen elektrischen Anlagenteilen. Bei ungenügendem Abstand oder ungenügender Isolation zwischen zwei elektrischen Potenzialen kann es zu einem ungewollten Spannungsüberschlag kommen, in dessen Verlauf ein Lichtbogen entsteht. Dieser Spannungsüberschlag kann auch in einem elektrischen Bauteil selber entstehen, weil sich die Kontakte zu langsam trennen, oder die Isolationsschicht zwischen den stromführenden Teilen ihrer Isolierfähigkeit beraubt wurde.

Die Lichtbögen, die bei Spannungsüberschlag entstehen, setzen in der Regel die Lebensdauer des Bauteils massiv herab und können es im schlimmsten Fall auch zerstören. Lichtbögen sind bei Hochspannung führenden Bauteilen eine erhebliche Gefahr. Durch die große Lichtbogenleistung und hohe Temperatur des Lichtbogens kommt es neben der starken Lichtwirkung zu einem lauten Knall und brennbare Gegenstände in unmittelbarer Umgebung können Feuer fangen. Es besteht Brandgefahr. Im Niederspannungsbereich können Störlichtbögen infolge von Störstellen in elektrischen Leitungen auftreten, meist Leitungsschäden wie z.B. beschädigte Isolation infolge von Leitungsquetschungen oder zu geringe Biegungsradien bei elektrischen Leitungen. Hier können Kriechströme durch Verschmutzungen und Ablagerungen entstehen, die sich in einem Störlichtbogen entzünden. Auch bei losen Kontakten bei nicht korrekt montierten Bauteilen oder durch abgeknickte Leitungen können Störlichtbögen beispielsweise durch ionisierte Gase zwischen den losen Leitungsenden entstehen. Auf Leiterplatten, besonders häufig in Schaltnetzteilen, richten Überschläge erheblichen Schaden an, weil sich das Leitermaterial (Kupfer) auf dem Leiterplattenmaterial als Metalldampfschicht niederschlägt und Kriechstrecken überbrückt. Falls kein Austausch der gesamten Baugruppe möglich ist, werden derartige Schäden durch Schlitze in der Platine behoben; die neue Kriechstrecke besteht aus einem Luftspalt. Als Vorsorgemaßnahme dienen Lötaugen mit Hohlniet, dickere Kupferschichten, mit Draht verstärkte Leiterzüge, gekammerte Gehäuse sowie reichlich dimensionierte Kriechstrecken. Dem steht die Miniaturisierung aufgrund des geringen Bauraums wie z.B. in Hybrid- und Elektrofahrzeugen entgegen. Lichtbögen müssen somit unbedingt vermieden bzw. für den Fall, dass es zur Lichtbogenbildung kommt, rasch gelöscht werden.

Bezüglich der Entstehung von Lichtbögen in Hochspannungs-DC Anwendungen, wie bspw. dem elektrischen Antriebsstrang eines Hybrid-Kfz müssen zur Lichtbogenerkennung die angeschlossenen Geräte wie Antriebsumrichter und DC/DC-Wandler mit geeigneten Sensoren überwacht werden. Als Reaktion auf einen erkannten Lichtbogen muss eine Abschaltung der Hochspannungsversorgung des vom Störlichtbogen / Lichtbogen betroffenen Geräts erfolgen bevor die im Lichtbogen umgesetzte Energie so hoch wird, dass der Lichtbogen auf das Gerätegehäuse überspringt oder aus dem Gerät austritt und damit einen Brandfall verursacht. Beim Auftreten eines Störlichtbogens entstehen in einem Gerät im Zeitbereich von Mikrosekunden nachteilig leitfähige Partikel (z.B. karbonisierte Isoliermaterialien, Ruß, Plasma, verdampfte metallische Leitmaterialien, etc.). Durch die thermische und elektromagnetische Wirkung des Störlichtbogens werden diese Partikel explosionsartig innerhalb des betroffenen Geräts verteilt. Diese Partikel werden als Ursache für das Zünden sekundärer Störlichtbögen innerhalb eines betroffenen Geräts betrachtet. Als Sensorik zur Erkennung eines Lichtbogens werden im Stand der Technik diverse Methoden vorgeschlagen. Zum einen findet eine Auswertung des Druckanstiegs durch thermische Wirkung eines Störlichtbogens innerhalb eines eingeschlossenen Gerätevolumens statt. Zum anderen wird die von einem Störlichtbogen im Gerät ausgesandten Strahlung (im sichtbaren und nicht sichtbaren Bereich) ausgewertet (siehe DE 20 2005 011 504 U1). Weiterhin wird die akustische Wirkung beim Entstehen eines Störlichtbogens ausgewertet oder die in einem Gerät umgesetzte Energie (Quellen- / Senken-Vergleich) saldiert.

Alternativ wird das von einem Lichtbogen erzeugte Hochfrequenz-Spektrums ausgewertet. Einige der genannten Verfahren sind nachteilig aufgrund des hierfür erforderlichen Aufwands an Sensorik und erforderlicher Rechenleistung zur Erkennung, bzw. aufgrund der Störanfälligkeit in der Anwendung in Hochspannungs-DC-Anwendungen stark eingeschränkt. Einige der Verfahren haben insoweit Einschränkungen, dass in Geräten mit unterteiltem Gehäuse mehrere Erkennungseinrichtungen erforderlich werden um eine zur Begrenzung der Lichtbogenenergie erforderliche Detektionszeit einzuhalten. Plausibilisierung und Verknüpfung mehrerer Einzelsensoren bedingen zusätzlichen Rechenaufwand und Aufbau- und Verbindungstechnik (AVT).

Es besteht daher der Bedarf nach einer Vorrichtung, durch die die Zündung sekundärer Lichtbögen im Gehäuse effektiv unterbunden wird.

### Offenbarung der Erfindung

Die erfindungsgemäße Sicherheitsvorrichtung nach Anspruch 1 hat die Vorteile, dass die Entstehung sekundärer Lichtbögen unterbunden wird und die Entstehung von Lichtbögen generell detektiert werden kann.

Erfindungsgemäß ist dazu eine Sicherheitsvorrichtung vorgesehen, wobei die Sicherheitsvorrichtung ein Gehäuse mit mindestens einem stromführenden Element umfasst, wobei das stromführende Element im Gehäuseinnenraum angeordnet ist und von dem Gehäuse umschlossen wird. Im Gehäuseinnenraum des Gehäuses ist ein Partikeldetektor angeordnet, der den Gehäuseinnenraum bezüglich der Entstehung von Partikeln überwacht. Vorteilhafterweise erkennt der Partikeldetektor die bei einem Lichtbogen entstehenden Partikel, sobald diese vom Entstehungsort (dem primären Lichtbogen) im Gesamtgerät ausgestreut werden. Werden Partikel im Gehäuse durch den Partikeldetektor erkannt, kann vorteilhafterweise eine Abschaltung der Hochspannungsversorgung des Gerätes erfolgen, wodurch einem evtl. entstehenden Brandfall vorgebeugt werden kann.

Durch die in den abhängigen Ansprüchen genannten Maßnahmen sind vorteilhafte Weiterbildungen des in dem unabhängigen Anspruch angegebenen Verfahrens möglich.

Erfindungsgemäß ist der Partikeldetektor eine Lichtschranke. Eine Lichtschranke ist in der Optoelektronik ein System, das die Unterbrechung eines Lichtstrahls erkennt und als elektrisches Signal anzeigt. Vorteilhafterweise können mittels der Lichtschranke bewegliche Objekte wie z.B. Partikel berührungslos detektiert werden.

Weiterhin ist erfindungsgemäß vorgesehen, dass der Partikeldetektor eine Strahlungsquelle (Sender) und einen Strahlungsempfänger (Empfänger) aufweist. Ein funktionaler Test der Lichtschranke (mit einem zwischen Strahlungsquelle und einem Strahlungsempfänger liegenden Detektionspfad), ist vorteilhafterweise jederzeit einfach über die beiden Lichtschranken-Komponenten Sender und Empfänger möglich.

Als Strahlungsquelle wird vorteilhaft eine Leuchtdiode oder eine Laserdiode verwendet. Als Leuchtdioden eignen sich beispielsweise solche mit einer Wellenlänge von 660 nm (sichtbares rotes Licht) oder Infrarot-LEDs mit 880-940 nm im Infrarotbereich. Infrarotlicht hat den Vorteil, auf dunklen Materialien eine höhere Reichweite zu erzielen, auch ist es für das menschliche Auge nicht sichtbar. Der Vorteil beim Rotlicht besteht in der einfacheren Einstellung des Sensorsystems durch den sichtbaren Lichtfleck. Für besonders präzise Anwendungen (Kleinteileerkennung, hohe Wiederholgenauigkeit) wird i. d. R. Licht aus einer Laserdiode eingesetzt.

Als Strahlungsempfänger werden vorzugsweise ein Fotowiderstand, eine Fotodiode oder ein Fototransistor eingesetzt.

Je mehr Licht auf den Fotowiderstand fällt, desto kleiner wird sein elektrischer Widerstand, wodurch die Detektion von Partikeln möglich ist. Im Vergleich zu anderen Lichtsensoren reagieren Fotowiderstände allerdings eher langsam.

Fotodioden hingegen werden unter anderem verwendet, um Licht in eine elektrische Spannung oder einen elektrischen Strom umzusetzen oder um mit Licht übertragene Informationen zu empfangen. Treten Partikel in den Lichtweg der Lichtschranke, trifft entsprechend weniger Licht auf den Empfänger, wodurch eine geringer elektrische Spannung registriert und somit auf das Vorhandensein von Partikeln im Gehäuse geschlossen werden kann.

Fototransistoren sind vorteilhafterweise wesentlich empfindlicher als Fotodioden, da sie gleichzeitig als Verstärker wirken.

Die Sicherheitsvorrichtung überwacht erfindungsgemäß den Strahlungsempfänger auf eine von einem Lichtbogen ausgesandte Strahlung. Ein Lichtbogen weist bei seiner Entstehung ein Hochfrequenz-Spektrum auf, das mittels des Strahlungsempfängers empfangen und anschließend ausgewertet werden kann. Es ist somit mittels der Lichtschranke nicht nur möglich, Partikel zu detektieren und somit die Entstehung von Sekundärlichtbögen zu vermeiden, sondern auch die Entstehung von Lichtbögen generell zu detektieren.

Zusätzlich ist vorteilhaft, die Lichtschranke an oder in einer Öffnung des Gehäuses anzuordnen. Alternativ ist die Lichtschranke zwischen Unterteilungen oder Abschottungen innerhalb des Gerätes eingebaut. Der mit der Entstehung eines Lichtbogens verbundene Druckanstieg am Entstehungsort führt zu einer kurzzeitigen Druckdifferenz zwischen Entstehungsort und restlichem Gehäuse, wodurch Partikel zwangsläufig durch vorhandene Öffnungen bzw. Gehäuseöffnung transportiert werden und daher an dieser Stelle - an der die Lichtschranke vorteilhafterweise angeordnet ist - sicher erkannt werden können.

Da ein Austritt der vom Störlichtbogen generierten Partikel aus dem Gerätegehäuse eher unerwünscht ist, verbietet es sich, zur Partikeldetektion zusätzliche Geräteöffnungen an der Außenseite des Geräts vorzusehen. Entsprechend werden als Öffnungen die in Geräten üblicherweise vorhandene Druckausgleichsöffnung (DAE) für das erfindungsgemäße Verfahren genutzt.

Weitere Merkmale und Vorteile der vorliegenden Erfindung werden dem Fachmann aus der nachfolgenden Beschreibung beispielhafter Ausführungsformen, die jedoch nicht als die Erfindung beschränkend auszulegen sind, unter Bezugnahme auf die beigelegten Zeichnungen ersichtlich.

### Kurze Beschreibung der Zeichnungen

Es zeigen:
- Fig. 1:: eine schematische Darstellung eines Fahrzeuges und der Sicherheitsvorrichtung;
- Fig. 2:: eine schematische Darstellung einer Sicherheitsvorrichtung;

Alle Figuren sind lediglich schematische Darstellungen des erfindungsgemäßen Verfahrens bzw. seiner Bestandteile gemäß Ausführungsbeispielen der Erfindung. Insbesondere Abstände und Größenrelationen sind in den Figuren nicht maßstabsgetreu wiedergegeben. In den verschiedenen Figuren sind sich entsprechende Elemente mit den gleichen Referenznummern versehen.

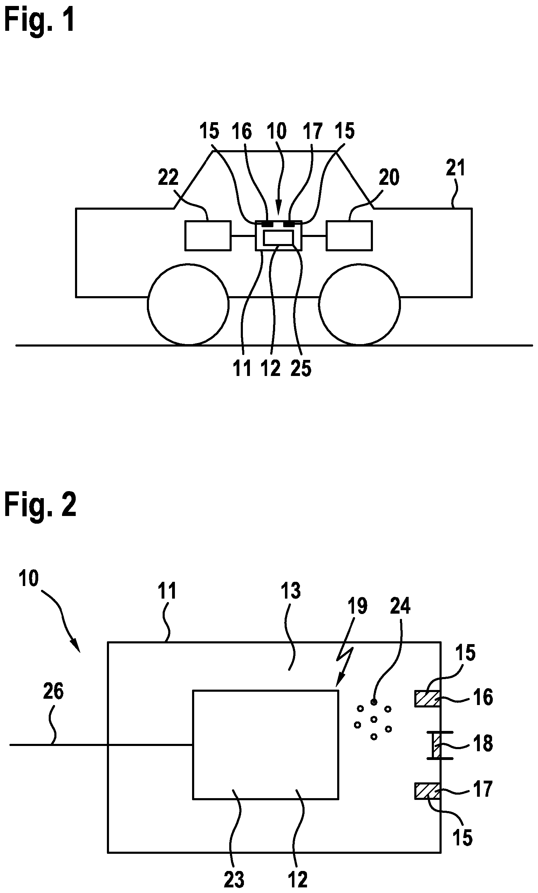

Figur 1 zeigt eine schematische Darstellung eines Fahrzeugs 21 mit einer Sicherheitsvorrichtung 10. Die Sicherheitsvorrichtung 10 umfasst ein Gehäuse 11. Dieses Gehäuse 11 besitzt einen Gehäuseinnenraum 13, in dem ein stromführendes Element 12 angeordnet ist. Bei dem stromführenden Element 12 kann es sich um beliebige Elektronikbauteile / -elemente handeln (z.B. Leistungselektronik 23, DCDC-Wandler 23, etc.), die von dem Gehäuse 11 umschlossen werden bzw. sich im Gehäuse 11 befinden. Die Sicherheitsvorrichtung 10 ist mit einer Batterie 22 und einem Elektromotor 20 verbunden und kann Teil einer Ladevorrichtung 25 (hier nicht dargestellt) sein.

Figur 2 zeigt eine schematische Darstellung einer Sicherheitsvorrichtung 10. Gleiche Elemente in Bezug auf Figur 1 sind mit gleichen Bezugszeichen versehen und werden nicht näher erläutert. Die Sicherheitsvorrichtung 10 umfasst ein Gehäuse 11, in dessen Gehäuseinnenraum 13 ein stromführendes Element 12 (eine Leistungselektronik 23, ein DCDC Wandler 23, etc.) angeordnet ist. Das Gehäuse 11 kann Unterteilungen bzw. Abschottungen innerhalb des Gehäuses 11 aufweisen. In dem Gehäuseinnenraum 13 ist ein Partikeldetektor 15 angeordnet.

Der Partikeldetektor 15 ist als Lichtschranke ausgeführt und besteht aus einer Strahlungsquelle 16 (Sender) und einem Strahlungsempfänger 17 (Empfänger).

Als Strahlungsquelle 16 wird vorteilhaft eine Leuchtdiode oder eine Laserdiode verwendet. Als Strahlungsempfänger 17 werden vorzugsweise ein Fotowiderstand, eine Fotodiode oder ein Fototransistor eingesetzt. Die Strahlungsquelle 16 sendet einen elektromagnetischen Strahl aus, der auf den Strahlungsempfänger 17 gerichtet ist. Treten Partikel 24 zwischen den Strahlungsempfänger 17 und die Strahlungsquelle 16 werden diese durch die Lichtschranke 15 registriert, was dazu führt, dass die Sicherheitsvorrichtung 10 die Spannungsversorgung 26 des stromführenden Elementes 12 abschaltet.

Weiterhin überwacht die Sicherheitsvorrichtung 10 den Strahlungsempfänger 17 auf eine von einem Lichtbogen 19 ausgesandte Strahlung. Entsteht ein Lichtbogen 19, wird die dabei entstehende Strahlung von dem Strahlungsempfänger 17 zusätzlich zu der von der Strahlungsquelle 16 ausgesandten Licht registriert. Die Strahlung des Lichtbogens 19 weist ein typisches Hochfrequenz-Spektrum auf, das auf die Entstehung eines Lichtbogens 19 hindeutet. Somit kann die Sicherheitsvorrichtung 10 bereits die Spannungsversorgung 26 abschalten, bevor mittels der Lichtschrank 15 überhaupt Partikel 24 detektiert worden sind. Der Partikeldetektor 15 ist an oder in einer Öffnung 18 des Gehäuses 11 angebracht. Entsteht ein Lichtbogen 19, wird die Luft um den Lichtbogen herum schlagartig erwärmt, wodurch es zu einem Druckanstieg am Entstehungsort des Lichtbogens 19 kommt. Die kurzzeitige Druckdifferenz zwischen Entstehungsort und dem restlichen Gehäuse 11 führt dazu, dass die Partikel 24 zwangsläufig durch vorhandene Gehäuseöffnungen wie z.B. die Öffnung 18 transportiert werden. Entsprechend werden die Partikel beim Durchtritt durch die Öffnung 18 durch den Partikeldetektor 15 sicher erkannt. Als Öffnung 18 wird beispielsweise die im Gehäuse 11 vorhandene Druckausgleichsöffnung genutzt.

## Patentansprüche

1. Sicherheitsvorrichtung (10), umfassend ein Gehäuse (11) mit mindestens einem stromführenden Element (12), das mit einer Spannungsversorgung (26) verbunden ist, wobei das stromführende Element (12) im Gehäuseinnenraum (13) angeordnet ist und von dem Gehäuse (11) umschlossen wird, wobei im Gehäuseinnenraum (13) des Gehäuses (11) ein Partikeldetektor (15) angeordnet ist, der ausgestaltet ist, den Gehäuseinnenraum (13) bezüglich der Entstehung von Partikeln (24) zu überwachen,
wobei der Partikeldetektor (15) eine Lichtschranke ist,
wobei die Lichtschranke eine Strahlungsquelle (16) und einen Strahlungsempfänger (17) aufweist,
wobei der Strahlungsempfänger (17) dazu eingerichtet ist, die von einem Lichtbogen ausgesandte Strahlung zu empfangen und auszuwerten und zu detektieren, wenn Partikel in den Lichtweg der Lichtschranke treten,
die Sicherheitsvorrichtung (10) ausgestaltet ist, beim Registrieren von Partikeln (24) durch die Lichtschranke die Spannungsversorgung (26) abzuschalten, die Sicherheitsvorrichtung (10) ausgestaltet ist, den Strahlungsempfänger (17) auf eine von einem Lichtbogen (19) ausgesandte Strahlung zu überwachen, indem die von dem Lichtbogen (19) ausgesandte Strahlung von dem Strahlungsempfänger (17) zusätzlich zur von der Strahlungsquelle ausgesandten Strahlung registrierbar ist,
die Sicherheitsvorrichtung (10) ausgestaltet ist, beim Registrieren der von dem Lichtbogen (19) ausgesandten Strahlung die Spannungsversorgung (26) abzuschalten, bevor die Partikel (24) von der Lichtschranke detektiert worden sind.

2. Sicherheitsvorrichtung (10) nach Anspruch 1, **dadurch gekennzeichnet, dass** als Strahlungsquelle (16) eine Leuchtdiode oder eine Laserdiode verwendet wird.

3. Sicherheitsvorrichtung (10) nach einem der vorhergehenden Ansprüche, **dadurch gekennzeichnet, dass** als Strahlungsempfänger (17) vorzugsweise eine Fotodiode, ein Fototransistor oder ein Fotowiderstand eingesetzt ist.

4. Sicherheitsvorrichtung (10) nach einem der vorhergehenden Ansprüche, **dadurch gekennzeichnet, dass** die Lichtschranke (15) an oder in einer Öffnung (18) des Gehäuses (11) angeordnet ist.

5. Sicherheitsvorrichtung (10) nach Anspruch 4, **dadurch gekennzeichnet, dass** die Öffnung (18) eine Druckausgleichsöffnung des Gehäuses (11) ist.

## Claims

1. Safety apparatus (10) comprising a housing (11) with at least one current-carrying element (12) which is connected to a voltage supply (26), wherein the current-carrying element (12) is arranged in the housing interior space (13) and is enclosed by the housing (11), wherein a particle detector (15) which is configured to monitor the housing interior space (13) with regard to the emergence of particles (24) is arranged in the housing interior space (13) of the housing (11),
wherein the particle detector (15) is a light barrier, wherein the light barrier has a radiation source (16) and a radiation receiver (17),
wherein the radiation receiver (17) is configured to receive and evaluate and detect the radiation emitted by an electric arc when particles enter into the light path of the light barrier,
the safety apparatus (10) is configured to switch off the voltage supply (26) when particles (24) are registered by the light barrier,
the safety apparatus (10) is configured to monitor the radiation receiver (17) for radiation emitted by an electric arc (19) by virtue of the fact that the radiation emitted by the electric arc (19) is able to be registered by the radiation receiver (17) in addition to the radiation emitted by the radiation source,
the safety apparatus (10) is configured to switch off the voltage supply (26) upon registration of the radiation emitted by the electric arc (19) before the particles (24) have been detected by the light barrier.

2. Safety apparatus (10) according to Claim 1, **characterized in that** a light-emitting diode or a laser diode is used as the radiation source (16).

3. Safety apparatus (10) according to either of the preceding claims, **characterized in that** preferably a photodiode, a phototransistor or a photoresistor is used as the radiation receiver (17).

4. Safety apparatus (10) according to any of the preceding claims, **characterized in that** the light barrier (15) is arranged at or in an opening (18) in the housing (11) .

5. Safety apparatus (10) according to Claim 4, **characterized in that** the opening (18) is a pressure equalization opening of the housing (11).

## Revendications

1. Dispositif de sécurité (10) comprenant un boîtier (11) pourvu d'au moins un élément conducteur de courant (12) qui est relié à une alimentation en tension (26), l'élément conducteur de courant (12) étant disposé dans l'espace intérieur du boîtier (13) et étant entouré par le boîtier (11), un détecteur de particules (15) étant disposé dans l'espace intérieur (13) du boîtier (11) et étant conçu pour surveiller l'espace intérieur (13) du boîtier en termes de formation de particules (24),
le détecteur de particules (15) étant une barrière lumineuse,
la barrière lumineuse comportant une source de rayonnement (16) et un récepteur de rayonnement (17),
le récepteur de rayonnement (17) étant conçu pour recevoir et évaluer et détecter le rayonnement émis par un arc lorsque des particules entrent dans le trajet de lumière de la barrière lumineuse, le dispositif de sécurité (10) étant conçu pour désactiver l'alimentation électrique (26) lorsque des particules (24) sont captées par la barrière lumineuse, le dispositif de sécurité (10) étant conçu pour surveiller le récepteur de rayonnement (17) en termes de rayonnement émis par un arc (19) en ce que le rayonnement émis par l'arc (19) peut être capté par le récepteur de rayonnement (17) en plus du rayonnement émis par la source de rayonnement,
le dispositif de sécurité (10) étant conçu pour désactiver l'alimentation en tension (26), lorsque le rayonnement émis par l'arc (19) est capté, avant que les particules (24) n'aient été détectées par la barrière lumineuse.

2. Dispositif de sécurité (10) selon la revendication 1, **caractérisé en ce qu'**une diode électroluminescente ou une diode laser est utilisée comme source de rayonnement (16).

3. Dispositif de sécurité (10) selon l'une des revendications précédentes, **caractérisé en ce qu'**une photodiode, un phototransistor ou une photorésistance est de préférence utilisé(e) comme récepteur de rayonnement (17).

4. Dispositif de sécurité (10) selon l'une des revendications précédentes, **caractérisé en ce que** la barrière lumineuse (15) est disposée au niveau d'une ouverture (18) du boîtier (11) ou dans celle-ci.

5. Dispositif de sécurité (10) selon la revendication 4, **caractérisé en ce que** l'ouverture (18) est une ouverture d'équilibrage de pression du boîtier (11).
